Europäisches Patentamt

European Patent Office

Office européen des brevets

(11) Veröffentlichungsnummer: **0 468 283 A1**

## (12) EUROPÄISCHE PATENTANMELDUNG

(21) Anmeldenummer: **91111499.9**

(22) Anmeldetag: **10.07.91**

(51) Int. Cl.5: **H05K 9/00**

(30) Priorität: **24.07.90 DE 4023509**

(43) Veröffentlichungstag der Anmeldung:
**29.01.92 Patentblatt 92/05**

(84) Benannte Vertragsstaaten:
**DE ES FR GB IT**

(71) Anmelder: **SIEMENS AKTIENGESELLSCHAFT**
**Wittelsbacherplatz 2**
**W-8000 München 2(DE)**

(72) Erfinder: **Wäger, Johann**
**Birkensteige 6**
**W-8535 Emskirchen(DE)**
Erfinder: **Haas, Hans**
**Rothenburger Strasse 5**
**W-8501 Grosshabersdorf(DE)**

(54) **Elektromagnetisch abschirmende Einrichtung, insbesondere ein Gehäuse, Schrank oder eine Kabine, aus blechartigem, korrosionsbeständigem Verbundwerkstoff; und Verwendung eines derartigen Verbundwerkstoffes für eine elektromagnetisch abschirmende Einrichtung.**

(57) Zum Aufbau von elektromagnetisch abschirmenden Einrichtungen bzw. Bauteilen, insbesondere von Gehäusen, Schränken, Kabinen, Wand-, Boden- und Deckenelementen, Modulen, Teilelementen, Türen, Fensterrahmen, Wabenkamineinsätzen und ähnlichem, wird ein blechartiger, korrosionsbeständiger Verbundwerkstoff verwendet. Dieser enthält ein Kernmaterial aus Stahlblech mit relativ hoher Schirmwirkung gegenüber magnetischen Feldern und ein Auflagematerial aus nichtrostendem Edelstahl auf dem Kernmaterial. Der Verbundwerkstoff weist eine Gesamtmaterialstärke von 1 bis mindestens 2,5 mm, bevorzugt von größer oder gleich 1,5 mm auf. Das Kernmaterial ist ein bevorzugt mit Titan legierter Tiefziehstahl. Das Auflagematerial ist bevorzugt ein zumindest mit Chrom legierter nichtrostender Stahl mit einer Stärke, welche pro Seite ca. 10 % der Gesamtmaterialstärke entspricht. Das Auflagematerial ist bevorzugt desweiteren mit Molybdän und/oder Nickel und/oder Titan legiert.

EP 0 468 283 A1

Die Erfindung betrifft eine elektromagnetisch abschirmende Einrichtung, und die Verwendung eines blechartigen, korrosionsbeständigen Verbundwerkstoffes zum Aufbau einer derartigen Einrichtung.

Eine Vielzahl von Einrichtungen müssen zum einen eine ausreichende Abschirmwirkung gegen von außen einfallende elektromagnetische Strahlung aufweisen. Zum anderen müssen Vorrichtungen, welche ihrerseits Erzeuger von starken, störenden elektromagnetischen Abstrahlungen sind, durch geeignete Kapselungen nach außen abgeschirmt werden. Als derartige, gegen einfallende bzw. abgehende elektromagnetische Strahlung abschirmende Einrichtungen sind anzusehen z.B. Gehäuse zur Aufnahme von elektrischen Geräten, wie Bildschirmen, Sendern und vieles mehr. Desweiteren müssen häufig Schränke elektromagnetisch abgeschirmt sein, welche z.B. in der Energieversorgungstechnik in Form von sogenannten Schaltschränken zur Aufnahme einer Vielzahl elektrischer Bauelemente dienen, die unter Umständen recht hohe Spannungen führen. Als weitere elektromagnetisch abschirmende Einrichtungen seien beispielhaft begehbare Kabinen genannt, welche in der Regel zur Aufnahme von Vorrichtungen dienen, die ihrerseits eine starke elektromagnetische Störstrahlung erzeugen. Als Beispiel seien hier Kabinen genannt, die z.B. in Form eines Fahrzeugaufbaues zur Aufnahme und zum Transport von funktechnischen Sende- und Empfangseinrichtungen dienen. Desweiteren können derartige Kabinen Untersuchungsgeräte aufnehmen, mit deren Hilfe eine Untersuchung des menschlichen Körpers nach dem Prinzip der sogenannten kernmagnetischen Resonanz möglich ist.

Desweiteren gibt es eine Vielzahl von elektromagnetisch abschirmenden Bauteilen, welche unter anderen zum Aufbau der obengenannten elektromagnetisch abschirmenden Einrichtungen dienen. So ist es z.B. bei sehr großen, elektromagnetisch abschirmenden Kabinen notwendig, die dazugehörigen Wand-, Boden- und Deckenelemente nicht einteilig, sondern in Form von miteinander mechanisch fest und elektrisch leitfähig verbundenen Modulen bzw. Teileelementen aufzubauen. Ferner werden bei derartigen Kabinen weitere elektromagnetisch abschirmende Bauteile benötigt, wie z.B. Türen und Fensterrahmen. Als derartige Bauteile sind auch sogenannte Wabenkamineinsätze zur elektromagnetisch abgeschirmten Be- und Entlüftung, Beleuchung oder Beschallung von abgeschirmten Räumen, Schränken oder Kabinen anzusehen. Aus der deutschen Gebrauchsmusteranmeldung mit dem Aktenzeichen G 88 10 813.9 ist beispielsweise ein derartiger Wabenkamineinsatz in zylinderförmiger Bauform bekannt.

Neben der elektromagnetischen Abschirmung der obengenannten Einrichtung und Bauteile spielt in der Praxis auch deren Korrosionsschutz eine wichtige Rolle. Hierunter fällt nicht nur der Korrosionsschutz von äußeren, in der Regel sichtbaren Oberflächen. Dieser ist zwar im Hinblick auf das ästhetische Erscheinungsbild notwendig und z.B. auf dem Wege einer zusätzlichen Oberflächenbehandlung durch Lackieren auf einfache Weise herzustellen. Dennoch steht im Hinblick auf die Erhaltung der elektromagnetisch abschirmenden Wirkung der Einrichtung ein derartiger Korrosionsschutz von außenliegenden Oberflächen nicht im Vordergrund. Vielmehr ist es hierzu notwendig, langfristig einen ausreichenden Korrosionsschutz auf sogenannten Kontaktflächen sicherzustellen. Insbesondere bei elektromagnetisch abschirmenden Einrichtungen, welche aus einer Vielzahl von einzelnen Bauteilen, z.B. Wand-, Boden-, Decken-, Tür- und Fensterelementen zusammengesetzt sind, muß ein ausreichender Korrosionsschutz auf den elektrisch leitenden Kontaktflächen zwischen den einzelnen Bauteilen der Einrichtung sichergestellt werden.

In der nachfolgenden Tabelle 1 sind Werkstoffe aufgelistet, aus denen elektromagnetisch abschirmende und zugleich korrosionsgeschützte Einrichtungen bzw. Bauteile üblicherweise hergestellt werden.

2

Tabelle 1

1a    Aluminium-Knetlegierungen:

z.B. AlMg3, DIN 1784


1b    Chrom-Nickel-Stahlbleche:

z.B. X5CrNi1810, DIN 17440


2a    feuerverzinkte Stahlbleche:

z.B. St 02 Z 275 NA/SB, DIN 17162


2b    Chrom-Stahlbleche:

z.B. X6Cr17, DIN 17440


Dabei kommen die unter Punkt 1a und 1b genannten Werkstoffe nur in wenigen Fällen zum Einsatz, da Aluminium-Knetlegierungen und Chrom-Nickel-Stahlbleche keine ausreichende relative Permeabilität aufweisen und somit als Schirmungswerkstoff zum Aufbau von elektromagnetisch abschirmenden Einrichtungen nur selten geeignet sind. Zudem weisen diese Werkstoffe auch bei der mechanischen Bearbeitung Nachteile auf, da z.B. aufgrund ihrer hohen Wärmeausdehnung beim Schweißen mit einem starken Verzug zu rechnen ist.

Vorzugsweise werden somit die unter Punkt 2a und 2b oder obigen Tabelle 1 genannten Werkstoffe, d.h. feuerverzinkte Stahlbleche bzw. Chrom-Stahlbleche, zum Aufbau von elektromagnetisch abschirmenden Einrichtungen bzw. Bauteilen verwendet. Doch auch diese Werkstoffe sind im Hinblick auf die gewünschten Eigenschaften einer guten elektromagnetischen Abschirmwirkung bei gleichzeitig gutem Korrosionsschutz insbesondere im Bereich von sogenannten Kontaktflächen mit einer Vielzahl von Nachteilen behaftet.

So weisen zwar feuerverzinkte Stahlbleche aufgrund ihrer hohen relativen Permeabilität eine recht hohe Abschirmwirkung im sogenannten magnetischen Feldbereich zwischen ca. 10 kHz und ca. 1 MHz Störstrahlungsfrequenz auf. Dennoch besteht bei verzinkten Stahlblechen die Gefahr der sogenannten Weißrostbildung. Tritt diese Korrosionsform auf sogenannten Kontaktflächen zwischen einzelnen Bauteilen einer elektromagnetisch abschirmenden Einrichtung auf, so nimmt auf der Kontaktfläche der elektrische Übergangswiderstand zu und insgesamt die Wirkung der elektromagnetischen Abschirmung der Einrichtung ab. Ein weiterer Nachteil verzinkter Stahlbleche ist deren schlechte Schweißeignung, da beim Schweißen zum einen hohe Emissionen von Zinkstaub und Zinkdämpfen entstehen und zum anderen verschweißte Oberflächen nachträglich z.B. mit Hilfe des aufwendigen thermischen Spritzverzinkens wieder nachgebessert werden müssen. Ferner müssen zumindest die als Kontaktflächen vorgesehenen Oberflächenbereiche eines aus verzinktem Stahlblech hergestellten elektromagnetisch abschirmenden Bauteiles vor der Montage besonders sorgfältig gereinigt werden, um eine ausreichende Leitfähigkeit an der Kontaktfläche sicherzustellen. Schließlich besteht bei verzinkten Stahlblechen häufig auch die Gefahr der sogenannten Kontaktkorrosion. Diese tritt dort auf, wo andere Werkstoffe, z.B. Kupfer-Berillium-Legierungen oder verzinnte Oberflächen mit der Oberfläche des verzinkten Stahlbleches in Kontakt treten. Derartige andere Werkstoffe werden bei elektromagnetisch abschirmenden Einrichtungen häufig für sogenannte Kontaktelemente bzw. Kontaktfedern verwendet. Derartige Kontaktfedern sorgen z.B. in den Bereichen zwischen der Außenkanten einer Tür und der Innenseite eines Türrahmens, oder einem Fensterrahmen und einer diesen umgebenden Fensterzarge für eine ausreichende elektromagnetisch abschirmende Kontaktierung beider Bauteile. Aufgrund des hohen elektrochemischen Spannungsunterschiedes zwischen einer verzinkten Oberfläche und derartigen Kontaktelementwerkstoffen besteht in derartigen Kontaktbereichen eine zusätzliche Korrosionsgefahr.

Demgegenüber verfügen Chrom-Stahlbleche zwar über eine relativ gute Schweißeignung, einen niedrigen Oberflächenwiderstand und eine geringeren elektrochemischen Spannungsunterschied zu den obengenannten Kontaktelementwerkstoffen. Dennoch weisen sie gerade im Hinblick auf die vorliegende Verwendung beim Aufbau von elektromagnetisch abschirmenden Einrichtungen den besonderen Nachteil auf, daß sie im Vergleich zu verzinkten Stahlblechen eine geringere realative Permeabilität haben. Ihre Schirmwirkung gegenüber elektromagnetischer Strahlung ist somit bei gleicher Materialstärke geringer.

Der Erfindung liegt die Aufgabe zugrunde, eine elektromagnetisch abschirmende Einrichtung bzw. ein Bauteil aus einem Werkstoff herzustellen, welcher sowohl über eine hohe relative Permeabilität und somit eine hohe Abschirmwirkung gegenüber elektromagnetischen Feldern verfügt, als auch bei guten Verarbeitungseigenschaften eine ausreichende Korrosionsbeständigkeit insbesondere von Kontaktflächen im Inneren der Einrichtung bzw. zwischen einzelnen Bauteilen derselben aufweist. Der Werkstoff der elektromagnetisch abschirmenden Einrichtung soll somit die bekannten Vorteile von verzinkten Stahlblechen und Chrom-Stahlblechen unter gleichzeitiger Vermeidung von deren wesentlichen Nachteilen miteinander vereinen.

Die Aufgabe wird gelöst durch eine elektromagnetisch abschirmende Einrichtung bzw. ein Bauteil, welche aus einem blechartigen, korrosionsbeständigen Verbundwerkstoff aufgebaut sind, wobei als Kernmaterial des Verbundwerkstoffes ein Stahlblech mit relativ hoher Schirmwirkung gegenüber elektromagnetischen Feldern und als Auflagematerial auf dem Kernmaterial des Verbundwerkstoffes ein nichtrostender Stahl dient. Die Aufgabe wird desweiteren durch die Verwendung eines blechartigen, korrosionsbeständigen Verbundwerkstoffes zum Aufbau elektromagnetisch abschirmender Einrichtungen bzw. Bauteile gelöst, wobei als Kernmaterial des Verbundwerkstoffes ein Stahlblech mit hoher Schirmwirkung gegenüber elektromagnetischen Feldern und als Auflagematerial auf dem Kernmaterial des Verbundwerkstoffes ein nichtrostender Stahl dient. Weitere vorteilhafte Ausführungsformen der Erfindung sind in den Unteransprüchen angegeben.

Die Erfindung wird desweiteren unter Zuhilfenahme einer Figur näher erläutert, in der frequenzabhängige Dämpfungskurven gegenüber einfallender elektromagnetischer Strahlung für verschiedenartige Werkstoffe dargestellt sind.

Der gemäß der Erfindung zum Aufbau von elektromagnetisch abschirmenden Einrichtungen bzw. Bauteile eingesetzte Verbundwerkstoff weist ein Kernmaterial und Deckschichten aus nichtrostendem Auflagematerial auf. Ein derartiger geschlossener Verbundwerkstoff wird auch als nichtrostender, plattierter Stahl bezeichnet. Dabei weist das Kernmaterial eine, für die Abschirmwirkung wichtige hohe relative Permeabilität in einer Größenordnung auf, welche der relativen Permeabilität von verzinktem Stahlblech entspricht. Besonders vorteilhaft wird als Kernmaterial des Verbundwerkstoffes ein Sondertiefziehstahl z.B. der Güte 1.0338 verwendet, welcher bei einer weiteren Ausführungsform besonders vorteilhaft zusätzlich mit Titan legiert ist. Als Kernmaterial kann somit ein Stahl mit der Bezeichnung St14(RR) DIN 1623 mit der Werkstoffnummer 1.0338Ti dienen.

Als Auflagematerial auf das Kernmaterial wird ein nichtrostender Stahl verwendet. Dieser ist zumindest mit Chrom legiert. Gemäß einer weiteren Ausführungsform kann der Auflagewerktoff desweiteren mit Molybdän und/oder Nickel und/oder Titan legiert sein. Als bevorzugte Werkstoffsorte können somit beispielhaft Stähle mit den Bezeichnungen X6CrMo171, X5CrNiMo17122 bzw. X6CrNiMoTi17122 jeweils nach DIN 17440 dienen. Bevorzugt beträgt die Stärke des Auflagematerial auf dem Kernmaterial des Verbundwerkstoffes pro Seite ca. 10 % der Gesamtmaterialstärke.

Zum Aufbau der erfindungsgemäßen elektromagnetisch abschirmenden Einrichtungen bzw. Bauteile ist beispielsweise ein unter dem Namen "PLATINOX" der KLÖCKNER STAHL GmbH angebotene Verbundwerkstoff geeignet.

Im allgemeinen hängt die Schirmwirkung eines blechartigen Werkstoffes gegenüber elektromagnetischer Strahlung neben der Blechdicke auch vom Produkt aus der Werkstoffleitfähigkeit und deren relativer Permeabilität ab. Dabei ist der Beitrag der relativen Permeabilität zur Schirmwirkung eine Funktion der Blechdicke und der Frequenz der Störstrahlung. Dabei ist es besonders schwierig, hohe Werte der Schirmdämpfung im sogenannten magnetischen Feldbereich bei Störstrahlungsfrequenzen zwischen ca. 10 kHz und ca. 1 MHz zu erreichen. Hierzu ist es vorteilhaft, wenn der Verbundwerkstoff eine Gesamtmaterialstärke im Bereich von 1 bis 2,5 mm aufweist. Ein guter Kompromiß zwischen ausreichender Schirmwirkung und mechanischer Stabilität einerseits, und nicht zu hohem Transportgewicht der elektromagnetisch abschirmenden Einrichtung bzw. des Bauteiles andererseits wird dadurch gefunden, daß gemäß einer besonders vorteilhaften Ausführung der Erfindung der Verbundwerkstoff eine Gesamtmaterialstärke von größer oder gleich 1,5 mm aufweist.

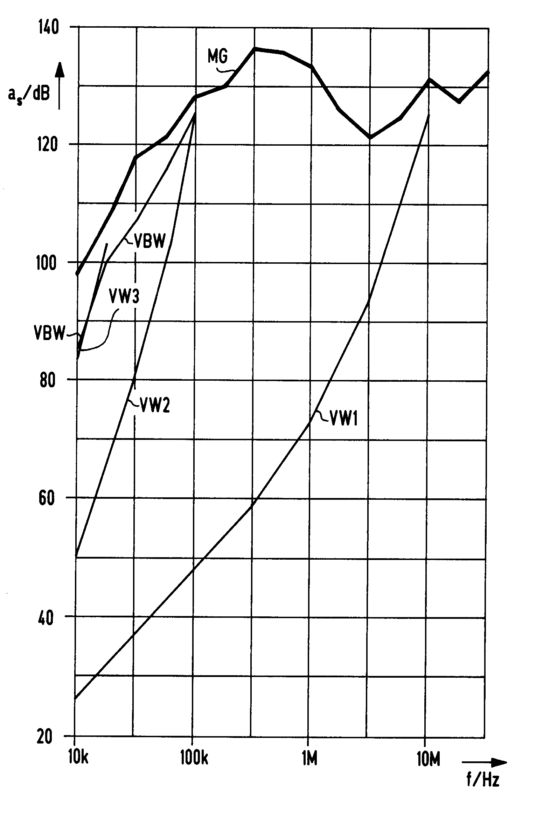

Der Zusammenhang zwischen Störstrahlungsfrequenz, Schirmdämpfung und Materialstärke wird für verschiedene Werkstoffe desweiteren anhand der in der Figur dargestellten Schirmdämpfungskurven näher erläutert. In der nachfolgenden Tabelle 2 sind dabei die den einzelnen Kurven zugrundeliegenden Werkstoffe zusammengestellt.

Tabelle 2

Schirmdämpfungskurven nach Figur
(gemessen nach MIL STD 285)

VW1: erster Vollwerkstoff:
Chrom-Nickel-Stahlblech (X5CrNi1810,
DIN 17440); Dicke: 1 mm, Werkstoffnummer
1.4301, austenitisches Gefüge

VW2: zweiter Vollwerkstoff:
Chrom-Stahlblech (X6Cr17, DIN 17440);
Dicke: 1 mm, Werkstoffnummer 1.4016
ferritisches Gefüge

VW3: dritter Vollwerkstoff:
feuerverzinktes Stahlblech (St 02 Z 275 NA/SB,
DIN 17162); Dicke: 1 mm

VBW: Verbundwerkstoff:
Grundwerkstoff: Tiefziehstahl (St14 (RR),
DIN 1623, Werkstoffnummer 1.0338Ti);
Auflagewerkstoff: rostfreier Stahl
(X6CrMo171, DIN 17440, Werkstoffnummer
1.4113); Gesamtmaterialstärke 1,5 mm;
Dicke Auflagewerkstoff pro Seite: 10 % Gesamtmaterialstärke.

So sind in der Figur Schirmdämpfungskurven zum einen für die bekannten Vollwerkstoffe Chrom-Nickel-Stahlblech (VW1), Chrom-Stahlblech (VW2) und feuerverzinktes Stahlblech (VW3) dargestellt. Alle drei Werkstoffe verfügen dabei über eine Gesamtmaterialstärke von 1 mm. Desweiteren ist in der Figur eine Schirmdämpfungskurve für einen Verbundwerkstoff gemäß der Erfindung dargestellt, welcher über eine Gesamtmaterialstärke von 1,5 mm verfügt. Aus der Figur ist zu erkennen, daß in dem besonders kritischen Störstrahlungsfrequenzbereich von ca. 10 kHz bis etwa 10 MHz der erste Vollwerkstoff Chrom-Nickel-Stahlblech (VW1) die schlechtesten Schirmdämpfungswerte aufweist. Bessere Schirmdämpfungswerte bietet im Vergleich dazu der zweite Vollwerkstoff Chrom-Stahlblech (VW2), während bei feuerverzinktem Stahlblech als drittem Vollwerkstoff (VW3) die beste Schirmdämpfung zu erwarten ist.

Demgegenüber ist aus der Figur zu erkennen, daß ein der Erfindung entsprechender Verbundwerkstoff VBW bei geringfügiger Vergrößerung der Gesamtmaterialstärke auf 1,5 mm Schirmdämpfungswerte aufweist, welche mit den sehr guten Werten von feuer verzinktem Stahlblech (VW3) vergleichbar sind. Würde die Gesamtmaterialstärke des Verbundwerkstoffes ebenfalls 1 mm betragen, so tritt immer noch eine Schirmdämpfungskurve auf, welche im Bereich zwischen den zum zweiten Vollwerkstoff VW2 und zum dritten Vollwerkstoff VW3 gehörigen Schirmdämpfungskurven liegt. Mit der erfindungsgemäßen Einführung von blechartigen, korrosionsgeschützten Verbundwerkstoffen beim Aufbau von elektromagnetisch abschirmenden Einrichtungen bzw. Bauteilen können somit zum einen im Vergleich zum bisherigen feuerverzinkten Stahlblech ähnlich gute Schirmwirkungen erzielt werden, und zum anderen die guten Korrosionseigenschaften der Edelstahloberfläche genutzt werden.

Die Verwendung der erfindungsgemäßen blechartigen, korrosionsgeschützten Verbundwerkstoffe weist eine Reihe von weiteren Vorteilen auf. So kann dieser Werkstoff zum Aufbau von elektromagnetisch abschirmenden Einrichtungen bzw. Bauteilen verwendet werden, ohne das irgendwelche mechanischen Veränderungen bzw. Umkonstruktionen an denselben notwendig sind. Desweiteren zeichnet sich der Verbundwerkstoff durch einen sehr geringen Oberflächenwiderstand und einen ausgezeichneten Korrosionsschutz insbesondere an sogenannten Kontaktflächen aus. Dabei handelt es sich um Flächen, bei denen z.B. durch Schraubverbindungen bzw. aufliegenden Kontaktfedern z.B. in Türrahmen bzw. Fensterrahmen eine elektrisch leitende Verbindung zwischen verschiedenen Bestandteilen der elektromagnetisch abschirmenden Einrichtung bzw. des Bauteiles hergestellt wird. Zudem sind vor einer Montage derartiger Teile nur geringe Reinigungsarbeiten insbesondere im Bereich der Kontaktflächen notwendig. Schließlich ist mit einer äußerst geringen Kontaktkorrosions zu rechnen, da nur geringe elektrochemische Spannungsunterschiede zwischen der Oberfläche des zumindest aus Chrom-Stahl bestehenden Auflagematerials und den für Kontaktelementen bzw. Kontaktfedern üblichen Werkstoffen, z.B. Kupfer-Berillium-Legierungen bzw. verzinnten Oberflächen, bestehen. Aufgrund der ausgezeichneten Korrosionsschutzeigenschaften des erfindungsgemäßen Verbundwerkstoffes ist es in besonderen Anwendungsfällen gegebenenfalls möglich, hieraus aufgebaute elektromagnetisch abschirmende Einrichtungen bzw. Bauteile ohne jegliche weitere Oberflächenbehandlungen bzw. Lackierungen auszuführen.

**Patentansprüche**

1. Elektromagnetisch abschirmende Einrichtung, insbesondere ein Gehäuse, Schrank oder eine Kabine, welche aus einem blechartigen, korrosionsbeständigem Verbundwerkstoff aufgebaut ist, wobei als Kernmaterial des Verbundwerkstoffes ein Stahlblech mit relativ hoher Schirmwirkung gegenüber elektromagnetischen Feldern und als Auflagematerial auf dem Kernmaterial des Verbundwerkstoffes ein nichtrostender Stahl dient.

2. Elektromagnetisch abschirmendes Bauteil, insbesondere ein Wand-, Boden- oder Deckenelement, Modul oder Teilelement, eine Tür, ein Fensterrahmen oder ein Wabenkamineinsatz, welches aus einem blechartigen, korrosionsbeständig Verbundwerkstoff aufgebaut ist, wobei als Kernmaterial des Verbundwerkstoffes ein Stahlblech mit relativ hoher Schirmwirkung gegenüber elektromagnetischen Feldern und als Auflagematerial auf dem Kernmaterial des Verbundwerkstoffes ein nichtrostender Stahl dient.

3. Vorrichtung nach Anspruch 1 oder 2, **dadurch gekennzeichnet,** daß der Verbundwerkstoff eine Gesamtmaterialstärke im Bereich von 1 bis mindestens 2,5 mm aufweist.

4. Vorrichtung nach Anspruch 3, **dadurch gekennzeichnet,** daß der Verbundwerkstoff eine Gesamtmaterialstärke von größer oder gleich 1,5 mm aufweist.

5. Vorrichtung nach einem der vorangegangenen Ansprüche, **dadurch gekennzeichnet,** daß als Kernmaterial des Verbundwerkstoffes ein Sondertiefziehstahl dient.

6. Vorrichtung nach einem der vorangegangenen Ansprüche, **dadurch gekennzeichnet,** daß das Kernmaterial des Verbundwerkstoffes mit Titan legiert ist.

7. Vorrichtung nach einem der vorangegangenen Ansprüche, **dadurch gekennzeichnet,** daß die Stärke des Auflagematerials auf dem Kernmaterial des Verbundwerkstoffes pro Seite ca. 10 % der Gesamtmaterialstärke beträgt.

8. Vorrichtung nach einem der vorangegangenen Ansprüche, **dadurch gekennzeichnet,** daß das Auflagematerial auf dem Kernmaterial ein zumindest mit Chrom legierter nichtrostender Stahl ist.

9. Vorrichtung nach Anspruch 8, **dadurch gekennzeichnet,** daß das Auflagematerial auf dem Kernmaterial des Verbundwerkstoffes desweiteren mit Molybdän und/oder Nickel und/oder Titan legiert ist.

10. Verwendung eines blechartigen, korrosionsbeständigen Verbundwerkstoffes zum Aufbau von elektromagnetisch abschirmenden Einrichtungen, insbesondere von Gehäusen, Schränken oder Kabinen, wobei als Kernmaterial des Verbundwerkstoffes ein Stahlblech mit relativ hoher Schirmwirkung gegenüber elektromagnetischen Feldern und als Auflagematerial auf dem Kernmaterial des Verbundwerkstoffes ein nichtrostender Stahl dient.

11. Verwendung eines blechartigen, korrosionsbeständigen Verbundwerkstoffes zum Aufbau von elektromagnetisch abschirmenden Bauteilen, insbesondere von Wand-, Boden- oder Deckenelementen, Modulen oder Teilelementen, Türen, Fensterrahmen oder Wabenkamineinsätzen, wobei als Kernmaterial des Verbundwerkstoffes ein Stahlblech mit relativ hoher Schirmwirkung gegenüber elektromagnetischen Feldern und als Auflagematerial auf dem Kernmaterial des Verbundwerkstoffes ein nichtrostender Stahl dient.

12. Verwendung nach Anspruch 10 oder 11, **dadurch gekennzeichnet,** daß der Verbundwerkstoff eine Gesamtmaterialstarke im Bereich von 1 bis mindestens 2,5 mm aufweist.

13. Verwendung nach Anspruch 12, **dadurch gekennzeichnet,** daß der Verbundwerkstoff eine Gesamtmaterialstärke von größer oder gleich 1,5 mm aufweist.

14. Verwendung nach einem der vorangegangenen Ansprüche 10 bis 13, **dadurch gekennzeichnet,** daß als Kernmaterial des Verbundwerkstoffes ein Sondertiefziehstahl dient.

15. Verwendung nach einem der vorangegangenen Ansprüche 10 bis 14, **dadurch gekennzeichnet,** daß das kernmaterial des Verbundwerkstoffes mit Titan legiert ist.

16. Verwendung nach einem der vorangegangenen Ansprüche 10 bis 15, **dadurch gekennzeichnet,** daß die Stärke des Auflagematerials auf dem Kernmaterial des Verbundwerkstoffes pro Seite ca. 10 % der Gesamtmaterialstärke beträgt.

17. Verwendung nach einem der vorangegangenen Ansprüche, **dadurch gekennzeichnet,** daß das Auflagematerial auf dem Kernmaterial ein zumindest mit Chrom legierter nichtrostender Stahl ist.

18. Verwendung nach Anspruch 17, **dadurch gekennzeichnet,** daß das Auflagematerial auf dem Kernmaterial des Verbundwerkstoffes desweiteren mit Molybdän und/oder Nickel und/oder Titan legiert ist.

# EUROPÄISCHER RECHERCHENBERICHT

Nummer der Anmeldung

**EP 91 11 1499**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | FR-A-2 627 005 (KOATSU GAS KOGYO CO.) <br> * das ganze Dokument * * <br> – – – | 1,6,8,9, 10,15,17 | H 05 K 9/00 |
| A,D | DE-U-8 810 813 (SIEMENS AG) <br> * das ganze Dokument * * <br> – – – | 1,5,10,14 | |
| A | EP-A-0 060 083 (ASAHI) <br> * das ganze Dokument * * <br> – – – – – | 1-18 | |

| | | | RECHERCHIERTE SACHGEBIETE (Int. Cl.5) |
|---|---|---|---|
| | | | H 05 K |

Der vorliegende Recherchenbericht wurde für alle Patentansprüche erstellt

| Recherchenort | Abschlußdatum der Recherche | Prüfer |
|---|---|---|
| Den Haag | 14 November 91 | TOUSSAINT F.M.A. |